# DEMANDE DE BREVET EUROPEEN

(11) **EP 4 572 537 A1**
(43) Date de publication de la demande: **18.06.2025**
(21) Numéro de dépôt: 24219528.7
(22) Date de dépôt: 12.12.2024
(51) Int. Cl.: H05K 1/02, H01L 23/552, H05K 1/18, H05K 3/28, H01L 23/31, H01L 23/538, H01L 25/065, H01L 25/16

(54) **MODULE ÉLECTRONIQUE, CARTE ÉLECTRONIQUE ET PROCÉDÉ DE FABRICATION D'UN MODULE ÉLECTRONIQUE**

(30) Priorité: 15.12.2023 FR 2314277
(71) Demandeur: THALES, 92190 Meudon (FR)
(72) Inventeur: GORAL, Benoît, 49309 CHOLET (FR)
(74) Mandataire: Lavoix

(57) **Abrégé**

La présente invention concerne un module électronique (10) comprenant :
- un circuit imprimé (12) présentant une face supérieure (20) et une face inférieure (22) et comprenant un conducteur de référence,
- des composants électriques (14A, 14B) montés sur la face supérieure (20) du circuit imprimé (12),
- une couche d'enrobage (16) enrobant les composants électriques (14A, 14B), et
- une cage de protection métallique (18) recouvrant la couche d'enrobage (16).
Les composants électriques (14A, 14B) incluent au moins un premier composant électrique (14A) comprenant un premier terminal de connexion (42A) et un deuxième terminal de connexion (44A), le premier terminal de connexion (42A) et le deuxième terminal de connexion (44A) étant décalés l'un par rapport à l'autre suivant une direction (Z) perpendiculaire à la face supérieure (20) du circuit imprimé (12), le deuxième terminal de connexion (44A) étant relié électriquement à la cage de protection métallique (18).

## Description

La présente invention concerne un module électronique, une carte électronique et un procédé de fabrication d'un module électronique.

Il est possible d'intégrer sur une carte électronique de nombreux composants électriques hétérogènes habituellement répartis en zones fonctionnelles, chaque zone fonctionnelle regroupant les composants électriques réalisant une fonction particulière, telle qu'une fonction d'alimentation, une fonction de traitement du signal, une fonction de contrôle graphique, une fonction d'interface graphique, ...

Il est possible de fabriquer une carte électronique par assemblage d'un ou plusieurs modules électroniques sur un circuit imprimé, chaque module électronique comprenant lui-même un circuit imprimé sur lequel sont montés des composants électriques. Les composants électriques de chaque module électronique peuvent être répartis en zones fonctionnelle, chaque zone fonctionnelle ayant une fonction respective.

Cette méthode de fabrication est appelée technologie PCMA (Printed Circuit Module Assembly, ce qui se traduit en français par assemblage de module de circuit imprimé).

Cette technologie PCMA présente les avantages d'augmenter la densification des zones fonctionnelles, tout en utilisant des techniques de fabrication économiques, même pour de faibles volumes de production.

Toutefois, la densification des zones fonctionnelles n'est pas entièrement satisfaisante et il existe un besoin de réduire davantage la taille de chaque module électronique, afin de réduire la taille globale de la carte électronique.

Le but de l'invention est alors de proposer un module électronique présentant une taille réduite, tout en conservant les mêmes fonctionnalités.

A cet effet, l'invention a pour objet un module électronique comprenant :
- un circuit imprimé présentant une face supérieure et une face inférieure opposées, le circuit imprimé comprenant un conducteur de référence,
- des composants électriques montés sur la face supérieure du circuit imprimé,
- une couche d'enrobage disposée sur la face supérieure du circuit imprimé en enrobant les composants électriques, la couche d'enrobage étant réalisée en un matériau diélectrique, et
- une cage de protection métallique recouvrant la couche d'enrobage,

les composants électriques incluant au moins un premier composant électrique comprenant un premier terminal de connexion et un deuxième terminal de connexion, le premier terminal de connexion et le deuxième terminal de connexion étant décalés l'un par rapport à l'autre suivant une direction perpendiculaire à la face supérieure du circuit imprimé, le deuxième terminal de connexion étant relié électriquement à la cage de protection métallique.

Selon des modes de mise en oeuvre particuliers, le module électronique comprend une ou plusieurs des caractéristiques optionnelles suivantes, prises isolément ou suivant toutes les combinaisons techniquement possibles :
- La cage de protection est reliée électriquement au conducteur de référence du circuit imprimé.
- Le premier composant électrique est un composant électrique passif, tel qu'un élément résistif, un élément capacitif ou un élément inductif.
- Le deuxième terminal de connexion du premier composant électrique est en contact avec la cage de protection.
- Le module électronique comprend un via reliant électriquement le deuxième terminal de connexion du premier composant électrique et la cage de protection.
- Le via est un passage métallisé, de préférence un orifice métallisé, en particulier un orifice métallisé de section transversale circulaire.

L'invention concerne également une carte électronique comprenant au moins un module électronique tel que décrit précédemment.

L'invention porte également sur un procédé de fabrication d'un module électronique, ledit procédé comprenant les étapes suivantes :
- une étape de montage de composants électriques sur une face supérieure d'un circuit imprimée, les composants électriques comprenant au moins un premier composant électrique comprenant un premier terminal de connexion et un deuxième terminal de connexion, le premier terminal de connexion et le deuxième terminal de connexion étant décalés l'un par rapport à l'autre suivant une direction perpendiculaire à la face supérieure du circuit imprimé,
- une étape de dépôt d'une couche d'enrobage réalisée en un matériau diélectrique et recouvrant la face supérieure du circuit imprimé, la couche d'enrobage enrobant les composants électriques, et
- une étape de dépôt de métal pour former une cage de protection métallique recouvrant la couche d'enrobage, le deuxième terminal de connexion du premier composant électrique étant relié électriquement à la cage de protection métallique.

Selon des modes de mise en oeuvre particuliers, le procédé comprend une ou plusieurs des caractéristiques optionnelles suivantes, prises individuellement ou selon toutes les combinaisons techniquement possibles :
- Après l'étape de dépôt de métal, le deuxième terminal de connexion du premier composant électrique est en contact avec la cage de protection.
- Le procédé comprend une étape supplémentaire, réalisée avant l'étape de dépôt de métal, de perçage d'un passage traversant la couche d'enrobage, l'étape de dépôt de métal comprenant le dépôt de métal dans le passage pour y former un via reliant le deuxième terminal de connexion du premier composant électrique à la cage de protection.

L'invention apparaîtra plus clairement à la lecture de la description qui va suivre, donnée uniquement à titre d'exemple non limitatif, et faite en référence aux dessins dans lesquels :
[Fig. 1] la figure 1 est une vue en coupe transversale d'un module électronique selon un premier mode de réalisation de l'invention ; et
[Fig. 2] la figure 2 est une vue en coupe transversale d'un module électronique selon un deuxième mode de réalisation de l'invention.

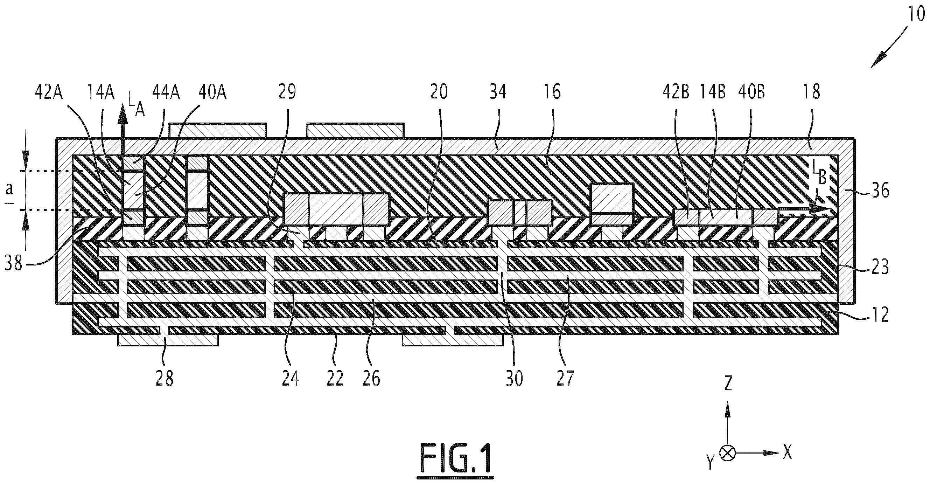

Le module électronique 10 illustré sur la Figure 1 est par exemple destiné à être monté sur un circuit imprimé d'une carte électronique (non représentée), éventuellement avec un ou plusieurs autres modules électroniques et/ou un ou plusieurs composants électriques montés directement sur le circuit imprimé de la carte électronique.

Le module électronique 10 comprend un circuit imprimé 12, des composants électriques 14A, 14B, une couche d'enrobage 16 et une cage de protection métallique 18.

Le module électronique 10 est par exemple configuré pour mettre en oeuvre une pluralité de fonctions individuelles, telles qu'une fonction audio, une fonction d'alimentation, une fonction de traitement du signal, une fonction de contrôle graphique, ou une fonction d'interface graphique.

Le circuit imprimé 12 présente une face supérieure 20 et une face inférieure 22 opposées l'une de l'autre, en particulier selon une direction d'extension Z.

Le circuit imprimé 12 présente également deux faces latérales 23 opposées l'une de l'autre selon une direction longitudinale X perpendiculaire à la direction d'extension Z.

Comme illustré sur la Figure 1, le circuit imprimé 12 est de préférence stratifié et comprend une pluralité de couches empilées les unes sur les autres, notamment entre la face supérieure 20 et la face inférieure 22, suivant la direction d'extension Z.

Plus particulièrement, le circuit imprimé 12 comprend au moins une couche isolante 24 et au moins une couche conductrice 26, 27, et avantageusement une alternance de couches isolantes 24 et de couches conductrices 26, 27.

Dans l'exemple illustré sur la Figure 1, le circuit imprimé 12 comprend cinq couches isolantes 24 et quatre couches conductrices 26, 27. Les couches conductrices 26, 27 sont par exemple intercalées entre les couches isolantes 24. De préférence, chaque couche conductrice 26, 27 est intercalée entre deux couches isolantes 24.

De préférence, chaque couche isolante 24 est réalisée dans un matériau diélectrique, comme par exemple une matrice en matériau plastique ou en résine, éventuellement renforcée de fibres, par exemple de fibres de verre. Un matériau comprenant une matrice en résine renforcée de fibres de verre est connu sous la désignation FR4.

De préférence, chaque couche conductrice 26, 27 est réalisée dans un matériaux conducteur d'électricité, comme par exemple un matériau métallique, notamment du cuivre ou un alliage de cuivre.

Le circuit imprimé 12 comprend un conducteur de référence, en particulier destiné à être relié à un potentiel électrique de référence. Un tel conducteur de référence est par exemple raccordé à la masse électrique.

Dans un exemple de réalisation, le conducteur de référence est une des couches conductrices 26, 27, nommée par la suite couche conductrice 26 de référence.

Dans l'exemple illustré sur la Figure 1, la couche conductrice 26 de référence correspond par exemple à la troisième couche conductrice du circuit imprimé 12 en partant de la face supérieure 20.

La couche conductrice 26 de référence est avantageusement configurée pour être portée à un potentiel électrique de référence, en étant de préférence reliée à la masse électrique.

Le circuit imprimé 12 comprend optionnellement des plots de connexion 28, 29 disposés sous la face inférieure 22 et/ou sur la face supérieure 20.

Les plots de connexion 28 sous la face inférieure 22 sont par exemple destinés à être connectés à des plots de connexion d'un circuit imprimé d'une carte électronique lors du montage du module électronique 10 sur ledit circuit imprimé ou à des plots de connexion d'un autre module électronique pour le montage du module électronique 10 sur ledit autre module électronique.

Les plots de connexion 29 sur la face supérieure 20 du circuit imprimé 12 sont par exemple destinés à être connectés aux composants électriques 14A, 14B.

Le circuit imprimé 12 comprend également avantageusement des via de liaison 30, chaque via de liaison 30 étant électriquement conducteur et s'étendant entre au moins deux des couches conductrices 26, 27 pour les relier électriquement entre elles ou entre au moins une des couches conductrices 26, 27 et un ou plusieurs plots de connexion 28, 29 pour les relier électriquement.

La couche d'enrobage 16 est disposée sur la face supérieure 20 du circuit imprimé 12 en enrobant les composants électriques 14A, 14B.

La couche d'enrobage 16 est réalisée en un matériau diélectrique.

Par exemple, la couche d'enrobage 16 est réalisée en résine, notamment en résine de type époxy.

La couche d'enrobage 16 présente par exemple une épaisseur, mesurée selon la direction d'extension Z, comprise entre 2 mm et 5 mm.

La couche d'enrobage 16 permet notamment de protéger les composants électriques 14A, 14B contre des infiltrations d'humidité.

Comme illustré sur la Figure 1, la cage de protection métallique 18 recouvre la couche d'enrobage 16.

Avantageusement, la cage de protection métallique 18 recouvre également au moins partiellement les faces latérales 23 du circuit imprimé 12.

En particulier, la cage de protection métallique 18 comprend une face supérieure 34 s'étendant sur la couche d'enrobage 16 et des portions latérales 36 recouvrant des faces latérales de la couche d'enrobage 16 et s'étendant de préférence vers le bas jusqu'à recouvrir au moins partiellement les faces latérales 23 du circuit imprimé 12.

De préférence, la cage de protection métallique 18 est reliée électriquement au conducteur de référence du circuit imprimé 12, en particulier à la couche conductrice de référence 26, notamment au niveau des faces latérales 23 du circuit imprimé 12.

En particulier, avantageusement le conducteur de référence, notamment la couche conductrice de référence 26, affleure une ou plusieurs faces latérales 23 du circuit imprimé 12 et/ou fait saillie d'une ou plusieurs faces latérales 23 du circuit imprimé 12 en étant raccordé électriquement à la cage de protection 18.

La cage de protection métallique 18 a par exemple une épaisseur comprise entre 5 µm et 50 µm.

La cage de protection métallique 18 permet notamment de protéger les composants électriques 14A, 14B et de réaliser un blindage électromagnétique du module électronique 10 dans son ensemble, vis-à-vis par exemple de perturbations électromagnétiques externes.

Les composants électriques 14A, 14B sont montés sur la face supérieure 20 du circuit imprimé 12, de préférence par brasage puis dépôt d'une couche de sous-remplissage 38, par exemple en matériau époxy.

Chaque composant électrique 14A, 14B est avantageusement choisi parmi un composant électrique passif, une composant électrique actif, un composant comportant un circuit intégré ou un microsystème électromécanique.

Comme illustré sur la Figure 1, chaque composant électrique 14A, 14B comprend par exemple un corps principal 40A, 40B.

Chaque composant électrique 14A, 14B comprend au moins un premier terminal de connexion 42A, 42B, de préférence pour connecter le composant électrique 14A, 14B au circuit imprimé 12, par exemple par le biais d'un des plots de connexion 29 sur la face supérieure 20 du circuit imprimé 12.

Le corps principal 40A,40B de chaque composant électrique 14A, 14AB s'étend par exemple suivant une direction longitudinale L du composant électrique 14A, 14B.

En particulier, comme cela est visible sur la Figure 1, le corps principal 40A, 40B de chaque composant électrique 14A, 14B est de longueur a s'étendant suivant la direction longitudinale L_{A}, L_{B} du composant électrique 14A, 14B.

Les composants électriques 14A, 14B incluent au moins un premier composant électrique 14A comprenant également un deuxième terminal de connexion 44A.

Le premier terminal de connexion 42A et le deuxième terminal de connexion 44A sont espacés l'un de l'autre suivant la direction longitudinale L_{A} du premier composant électrique 14A.

Plus particulièrement, le premier terminal de connexion 42A est espacé du deuxième terminal de connexion 44A suivant la longueur a du corps principal 40A.

Le premier terminal de connexion 42A et le deuxième terminal de connexion 44A sont par exemple disposés de part et d'autre du corps principal 40A. Le corps principal 40A est situé entre le premier terminal de connexion 42A et le deuxième terminal de connexion 44A.

Le premier terminal de connexion 42A et le deuxième terminal de connexion 44A sont par exemple disposés à deux extrémités opposées du premier composant électrique 14A suivant la direction longitudinale L_{A} du premier composant 14A.

Comme illustré sur la Figure 1, le premier composant électrique 14A est orienté de telle manière que le premier terminal de connexion 42A est plus proche de la face supérieure 20 du circuit imprimé 12 que le deuxième terminal de connexion 44A et le deuxième terminal de connexion 44A est plus éloigné de la face supérieure 20 du circuit imprimé 12 que le premier terminal de connexion 42A.

En particulier, le deuxième terminal de connexion 44A est plus proche de la face supérieure 34 de la cage de protection 18 que le premier terminal de connexion 42A et le premier terminal de connexion 42A est plus éloigné de la face supérieure 34 de la cage de protection 18 que le deuxième terminal de connexion 44A.

Le premier terminal de connexion 42A et le deuxième terminal de connexion 44A sont décalés l'un par rapport à l'autre suivant une direction perpendiculaire à la face supérieure 20, i.e. ici suivant la direction d'extension Z.

La direction longitudinale L_{A} du premier composant électrique 14A est inclinée d'un angle non nul par rapport à la face supérieure 20.

La direction longitudinale L_{A} du premier composant électrique 14A est en particulier perpendiculaire à la face supérieure 20 du circuit imprimé 12, i.e. ici parallèle à la direction d'extension Z.

Dans des exemples de réalisation, le premier terminal de connexion 42A et le deuxième terminal de connexion 44A du premier composant électrique 14A sont alignés suivant une direction perpendiculaire à la face supérieure 20, i.e. ici suivant la direction d'extension Z.

Plus particulièrement, la longueur a du corps principal 40A du premier composant électrique 14A s'étend suivant une direction perpendiculaire à la face supérieure 20, i.e. ici suivant la direction d'extension Z.

Le premier composant électrique 14A est ainsi agencé « debout » ou « relevé » sur le circuit imprimé 12.

La surface occupée par le premier composant électrique 14A sur le circuit imprimé 12 selon un tel agencement « debout » s'en trouve donc réduite par rapport à un agencement « allongé ».

Par agencement « allongé », on entend un composant électrique agencé de sorte que la direction longitudinale L_{B} du corps principal 40B s'étende parallèlement à la direction longitudinale X, comme par exemple le composant électrique 14B représenté à droite de la Figure 1.

Dans l'exemple illustré sur la Figure 1, les composants électriques 14A, 14B incluent deux premiers composants électriques 14A agencés « debout ».

De préférence, chaque premier composant électrique 14A est un composant électrique passif, tel qu'un élément résistif, un élément capacitif ou un élément inductif.

Comme illustré sur la Figure 1, le premier terminal de connexion 42A de chaque premier composant électrique 14A est connecté à un des plots de connexion 29 sur la face supérieure 20 du circuit imprimé 12.

En particulier, le premier terminal de connexion 42A est relié électriquement au circuit imprimé sans l'utilisation de câblage par fil ou pontage (dénommé wire bonding en anglais).

Le deuxième terminal de connexion 44A de chaque premier composant électrique 14A est relié électriquement à la cage de protection métallique 18.

Par exemple dans le mode de réalisation de la Figure 1, le deuxième terminal de connexion 44A du premier composant électrique 14A est en contact avec la cage de protection 18, plus précisément la face supérieure 34 de la cage de protection 18, en particulier de sorte à assurer la connexion électrique entre ces deux éléments.

Le deuxième terminal de connexion 44A de chaque premier composant électrique 14A est ainsi avantageusement relié électriquement au conducteur de référence du circuit imprimé 12 par le biais de la cage de protection 18.

Un procédé de fabrication d'un tel module électronique 10 va maintenant être décrit.

Le procédé comprend de préférence une première étape de montage des composants électriques 14A, 14B sur le circuit imprimé 12, et notamment sur sa face supérieure 20.

Avantageusement, lors de cette première étape de montage, les composants électriques 14A, 14B sont montés sur la face supérieure 20 du circuit imprimé 12 selon la technologie CMS (acronyme de l'anglais « Composant Mounted Surface » signifiant composant monté en surface).

Plus particulièrement, les composants électriques 14A, 14B sont brasés à la surface du circuit imprimé 12. Ensuite une couche de sous-remplissage 38, par exemple en matériau époxy, est déposée sur la face supérieure 20 du circuit imprimé 12.

Lors de cette première étape de montage, au moins un composant électrique, et par exemple deux composants électriques (par la suite qualifiés de premiers composants électriques 14A) comprenant un premier terminal de connexion 42A et un deuxième terminal de connexion 44A sont montés « debout » sur le circuit imprimé 12.

Autrement dit, le premier terminal de connexion 42A et le deuxième terminal de connexion 44A sont décalés l'un par rapport à l'autre suivant une direction perpendiculaire à la face supérieure 20 du circuit imprimé 12, en particulier suivant la direction d'extension Z.

De préférence, comme illustré sur la Figure 1, le premier terminal de connexion 42A de chaque premier composant électrique 14A est connecté à un des plots de connexion 29 sur la face supérieure 20 du circuit imprimé 12.

Le procédé comprend ensuite une étape de dépôt de la couche d'enrobage 16 réalisée en un matériau diélectrique et recouvrant la face supérieure 20 d'un circuit imprimé 12 en enrobant les composants électriques 14A, 14B.

Par exemple, cette étape de dépôt de la couche d'enrobage 16 est réalisée par pulvérisation d'un matériau diélectrique, comme de la résine par exemple.

Avantageusement, le procédé comprend ensuite une étape de ponçage de la couche d'enrobage 16 de sorte que la face supérieure de ladite couche d'enrobage 16 s'étende au même niveau que le deuxième terminal de connexion 44A de chaque premier composant électrique 14A.

Le procédé comprend ensuite une étape de dépôt de métal pour former la cage de protection métallique 18 recouvrant la couche d'enrobage 16.

De préférence, lors de cette étape, la cage de protection 18 est reliée électriquement au conducteur de référence du circuit imprimé 12.

Avantageusement, le deuxième terminal de connexion 44A de chaque premier composant électrique 14A est relié électriquement à la cage de protection métallique 18, et de préférence au conducteur de référence du circuit imprimé 12.

En particulier, à cet effet, le deuxième terminal de connexion 44A de chaque premier composant électrique 14A est en contact avec la cage de protection 18. Plus précisément, la cage de protection 18 est directement déposée sur une face supérieure de deuxième terminal de connexion 44A, grâce notamment à l'étape préalable de ponçage.

De préférence, le procédé comprend ensuite une étape de marquage, de test et/ou de conditionnement du module électronique 10.

Le marquage comprend par exemple un indicateur de polarité, une référence produit et une référence de lot.

Le module électronique 10 selon l'invention est particulièrement avantageux, en ce que l'agencement du ou des premiers composants électriques 14A selon un agencement « debout » permet de réduire la surface occupée par le ou lesdits premiers composants électriques 14A sur le circuit imprimé 12.

Il est ainsi possible de réduire la taille du circuit imprimé 12 et donc du module électronique 10, tout en conservant les mêmes composants donc les mêmes fonctionnalités.

Par ailleurs, la réduction de la taille du circuit imprimé 12 permet une réduction du poids et du coût de celui-ci.

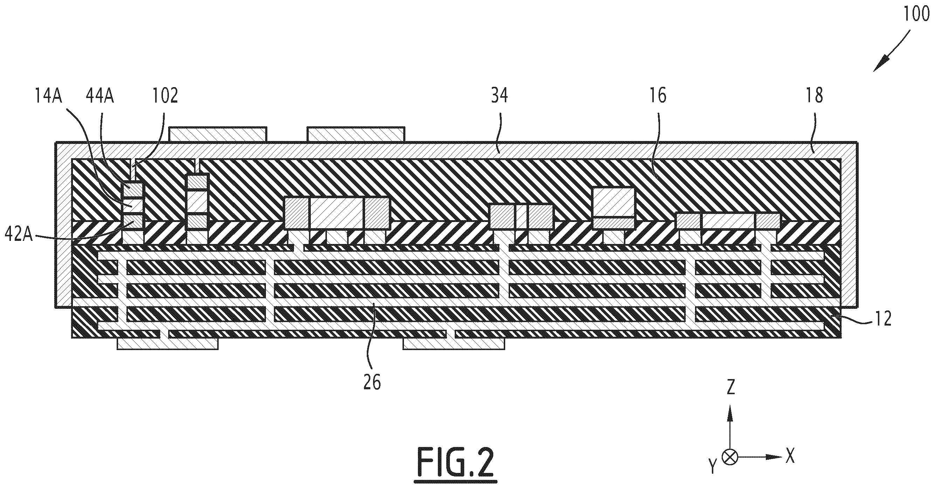

En référence à la Figure 2, on décrit un module électronique 100 selon un deuxième mode de réalisation de l'invention. Le module électronique 100 est analogue au module électronique 10 représenté sur la Figure 1. Les éléments similaires portent les mêmes références numériques et ne seront pas décrits à nouveau. Seules les différences seront décrites en détail ci-après.

Comme illustré sur la Figure 2, le module électronique 100 comprend au moins un via 102 reliant électriquement la cage de protection 18 et le deuxième terminal de connexion 44A du ou de l'un des premier composant électrique 14A.

En particulier, le module électronique 100 comprend un via 102 reliant électriquement le deuxième terminal de connexion 44A du premier composant électrique 14A et la cage de protection 18, pour chaque premier composant électrique 14A qui n'est pas en contact avec la cage de protection 18.

Chaque via 102 s'étend avantageusement à l'intérieur de la couche d'enrobage 16, et en particulier à l'écart des portions latérales de ladite couche d'enrobage 16.

Autrement dit, chaque via 102 est par exemple délimité latéralement par la couche d'enrobage 16 s'étendant tout autour du via 102. De préférence, un ou chaque via 102 est un passage métallisé, de préférence un orifice métallisé, en particulier un orifice métallisé de section transversale circulaire.

Chaque via 102 s'étend par exemple dans la couche d'enrobage 16 selon la direction d'extension Z.

En particulier, chaque via 102 s'étend entre la face supérieure 34 de la cage de protection 18 et le deuxième terminal de connexion 44A du premier composant électrique 14C associé à ce via 102.

Plus particulièrement, chaque via de protection 20 a ses dimensions transversales, prises perpendiculairement à la direction d'extension Z au travers de la couche d'enrobage 16, comprises entre 100 µm et 300 µm, et de préférence entre 100 µm et 250 µm.

Dans le cas où le via 102 est un orifice métallisé de section transversale circulaire, la dimension transversale correspond au diamètre de la section circulaire.

Dans ce mode de réalisation particulier, le deuxième terminal de connexion 44A de chaque premier composant électrique 14A n'est pas forcément en contact avec la cage de protection 18. Ce mode de réalisation présente l'avantage de pouvoir utiliser différents premiers composants électriques 14A de longueur a différente.

Le procédé de fabrication d'un tel module électrique 100 diffère de celui de fabrication du module électronique 10 du premier mode de réalisation en qu'il comprend une étape supplémentaire, réalisée avant l'étape de dépôt de métal, de perçage d'au moins un passage traversant la couche d'enrobage 16, et avantageusement d'un passage par premier composant électrique 14A.

Avantageusement, chaque passage s'étend entre une face supérieure de la couche d'enrobage 16 et le deuxième terminal de connexion 44A du premier composant électrique 14A associé.

Le perçage du ou des passages est réalisé par perçage laser.

L'étape de dépôt de métal comprend de préférence le dépôt de métal dans chaque passage pour y former un via 102 reliant le deuxième terminal de connexion 44A du premier composant électrique 14A associé à la cage de protection 18.

L'invention n'est pas limitée aux exemples de réalisation et aux variantes décrits auparavant et illustrés sur les dessins. D'autres exemples de réalisation et d'autres variantes sont envisageables.

Selon une autre variante, le circuit imprimé 12 comprend un nombre de couches conductrices 26 ,27 différents de quatre.

Par exemple, le circuit imprimé 12 comprend une unique couche conductrice 27. Dans cet exemple, le circuit imprimé 12 comprend de préférence une ceinture de conducteur reliée au potentiel de référence.

Dans un autre exemple, circuit imprimé 12 comprend un nombre de couches conductrices 26, 27 compris entre deux et quatre ou supérieur à quatre.

Dans un mode de mise en oeuvre particulier, plusieurs modules électroniques 10 sont fabriqués simultanément sur une même plaque de circuit imprimé regroupant plusieurs circuits imprimés 12 initialement solidaires, par le procédé tel que décrit ci-dessus, ce mode de mise en oeuvre comprenant la séparation des circuits imprimés 12.

En particulier, dans ce mode de mise en oeuvre, le procédé comprend, avant l'étape de dépôt de métal, une étape de sciage de passages s'étendant entre la face supérieure de la couche d'enrobage 16 et la couche de référence 26 des circuits imprimés 12. Chaque passage définit une frontière entre deux modules électroniques 10 adjacents.

Par ailleurs, le procédé comprend, suite à l'étape de dépôt de métal, une étape de séparation de la pluralité de modules électroniques 10 ainsi formés, de préférence par un sciage des passages jusqu'à la face inférieure 22 de chacun des circuit imprimés 12. On obtient ainsi une pluralité de modules électroniques 10 séparés les uns des autres.

## Revendications

1. Module électronique (10) comprenant :
- un circuit imprimé (12) présentant une face supérieure (20) et une face inférieure (22) opposées, le circuit imprimé (12) comprenant un conducteur de référence,
- des composants électriques (14A, 14B) montés sur la face supérieure (20) du circuit imprimé (12),
- une couche d'enrobage (16) disposée sur la face supérieure (20) du circuit imprimé (12) en enrobant les composants électriques (14A, 14B), la couche d'enrobage étant réalisée en un matériau diélectrique, et
- une cage de protection métallique (18) recouvrant la couche d'enrobage (16), les composants électriques (14A, 14B) incluant au moins un premier composant électrique (14A) comprenant un premier terminal de connexion (42A) et un deuxième terminal de connexion (44A), le premier terminal de connexion (42A) et le deuxième terminal de connexion (44A) étant décalés l'un par rapport à l'autre suivant une direction (Z) perpendiculaire à la face supérieure (20) du circuit imprimé (12), le deuxième terminal de connexion (44A) étant relié électriquement à la cage de protection métallique (18).

2. Module électronique (10) selon la revendication 1, dans lequel la cage de protection (18) est reliée électriquement au conducteur de référence du circuit imprimé (12).

3. Module électronique (10) selon la revendication 1 ou 2, dans lequel le premier composant électrique (14A) est un composant électrique passif, tel qu'un élément résistif, un élément capacitif ou un élément inductif.

4. Module électronique (10) selon l'une quelconque des revendications précédentes, dans lequel le deuxième terminal de connexion (44A) du premier composant électrique (14A) est en contact avec la cage de protection (18).

5. Module électronique (10) selon l'une quelconque des revendications 1 à 3, comprenant un via (102) reliant électriquement le deuxième terminal de connexion (44A) du premier composant électrique (14A) et la cage de protection (18).

6. Module électronique (10) selon la revendication 5, dans lequel le via (102) est un passage métallisé, de préférence un orifice métallisé, en particulier un orifice métallisé de section transversale circulaire.

7. Carte électronique comprenant au moins un module électronique (10) selon l'une quelconque des revendications précédentes.

8. Procédé de fabrication d'un module électronique (10) selon l'une quelconque des revendications précédentes, ledit procédé comprenant les étapes suivantes :
- une étape de montage de composants électriques (14A, 14B) sur une face supérieure (20) d'un circuit imprimée (12), les composants électriques (14A, 14B) comprenant au moins un premier composant électrique (14A) comprenant un premier terminal de connexion (42A) et un deuxième terminal de connexion (44A), le premier terminal de connexion (42A) et le deuxième terminal de connexion (44A) étant décalés l'un par rapport à l'autre suivant une direction (Z) perpendiculaire à la face supérieure (20) du circuit imprimé (12),
- une étape de dépôt d'une couche d'enrobage (16) réalisée en un matériau diélectrique et recouvrant la face supérieure (20) du circuit imprimé (12), la couche d'enrobage (16) enrobant les composants électriques (14A, 14B), et
- une étape de dépôt de métal pour former une cage de protection métallique (18) recouvrant la couche d'enrobage (16), le deuxième terminal de connexion (44A) du premier composant électrique (14A) étant relié électriquement à la cage de protection métallique (18).

9. Procédé de fabrication selon la revendication 8, dans lequel après l'étape de dépôt de métal, le deuxième terminal de connexion (44A) du premier composant électrique (14A) est en contact avec la cage de protection (18).

10. Procédé de fabrication selon la revendication 8, comprenant une étape supplémentaire, réalisée avant l'étape de dépôt de métal, de perçage d'un passage traversant la couche d'enrobage (16), l'étape de dépôt de métal comprenant le dépôt de métal dans le passage pour y former un via (102) reliant le deuxième terminal de connexion (44A) du premier composant électrique (14A) à la cage de protection (18).
